# EUROPEAN PATENT APPLICATION

(11) **EP 4 141 954 A1**
(43) Date of publication of application: **01.03.2023**
(21) Application number: 22192689.2
(22) Date of filing: 29.08.2022
(51) Int. Cl.: H01L 29/41, H01L 29/778, H01L 29/10, H01L 29/20

(54) **FIELD EFFECT TRANSISTOR, PRODUCTION METHOD THEREOF, AND ELECTRONIC CIRCUIT**

(30) Priority: 30.08.2021 CN 202111001372
(71) Applicant: Huawei Technologies Co., Ltd., Shenzhen, Guangdong 518129 (CN)
(72) Inventor: YI, Hongsheng, Shenzhen, 518129 (CN); YANG, Gangyi, Shenzhen, 518129 (CN); HUANG, Huidong, Shenzhen, 518129 (CN); WANG, Hanxing, Shenzhen, 518129 (CN)
(74) Representative: Pfenning, Meinig & Partner mbB

(57) **Abstract**

This application provides a field effect transistor, a production method thereof, and an electronic circuit. The field effect transistor includes a channel layer (2), a control gate (3), a passivation layer (4), a gate metal layer (5), an inter-layer dielectric layer (6), and a source-drain metal layer (7) that are sequentially stacked on a substrate (1). The gate metal layer includes a metal gate (51) and a step (52) that are disposed at a spacing. The source-drain metal layer includes a source (71), a drain (72), and a field plate (73) electrically connected to the source. The field plate extends from the source to one side of the drain and is disposed to be disconnected from the drain. The field plate specifically includes a first-order field plate (731) and a second-order field plate (732) whose orthographic projections on the substrate are located between the metal gate and the drain. The second-order field plate is a part covering the step, and the first-order field plate is a part other than the second-order field plate. A pattern of the step is also formed while a pattern of the metal gate is formed on the gate metal layer, so that the part covering the step at the source-drain metal layer is raised to form the second-order field plate. In this way, an entire field plate needs to be processed by performing a patterning process for only one time. Therefore, complexity and industrial costs of a production process of a field plate are reduced.

## Description

### TECHNICAL FIELD

This application relates to the field of semiconductor technologies, and in particular, to a field effect transistor, a production method thereof, and an electronic circuit.

### BACKGROUND

GaN (GaN) has advantages such as a large band gap and high mobility. Therefore, the GaN is widely used in substrate materials in the field of power devices. The GaN is mostly widely used in a high electron mobility transistor (High Electron Mobility Transistor, HEMT) in the field of power devices. In a high-power and high-withstand voltage HEMT device, to increase withstand voltage strength of a gate, a metal at a source end is usually led out, and bypasses the gate to form a field plate, to improve field strength distribution in a vertical direction between the gate and a drain, so that the gate is protected. Currently, in the industry, a structure of two field plates is used for a device with a voltage above 600 V. The two field plates are disposed at a specific location between the gate and the drain. After being connected to a low potential of a source, the field plates form electric field gradient distribution with a high voltage of the drain, to further protect the gate. Although an existing dual-field plate structure can electrically protect the gate, a plurality of processes are added to form a second-order field plate, and a process flow is complex.

### SUMMARY

This application provides a field effect transistor, a production method thereof, and an electronic circuit, to reduce a production process of a second-order field plate.

According to a first aspect, this application provides a field effect transistor, including a channel layer on a substrate, a control gate on the channel layer, a passivation layer on the control gate, a gate metal layer on the passivation layer, an inter-layer dielectric layer on the gate metal layer, and a source-drain metal layer on the inter-layer dielectric layer. The passivation layer includes a gate opening that exposes the control gate. The gate metal layer includes a metal gate and a step that are disposed at a spacing. The metal gate is electrically connected to the control gate through the gate opening. A source opening and a drain opening that pass through the inter-layer dielectric layer and the passivation layer are respectively located on two sides of the metal gate. An orthographic projection of the step on the substrate is located between the drain opening and the metal gate. The source-drain metal layer includes a source and a drain that are respectively located on two sides of the metal gate, and a field plate electrically connected to the source. The source is electrically connected to the channel layer through the source opening, and the drain is electrically connected to the channel layer through the drain opening. The field plate extends from the source to one side of the drain and is disposed to be disconnected from the drain. An orthographic projection of the field plate on the substrate has an overlapping area with the step. The field plate specifically includes a first-order field plate and a second-order field plate whose orthographic projections on the substrate are located between the metal gate and the drain. The second-order field plate is a part covering the step, and the first-order field plate is a part other than the second-order field plate.

According to the field effect transistor provided in this embodiment of this application, a pattern of the step is also formed while a pattern of the metal gate is formed on the gate metal layer, so that a part that is of the source-drain metal layer and that covers the step is raised to form the second-order field plate, a height difference is formed between the second-order field plate and a part that is not raised by the step, and the part that is not raised by the step forms the first-order field plate. In this way, an entire field plate needs to be processed by performing a patterning process for only one time. In other words, the entire field plate is formed by performing each of metal deposition, photoetching, and etching for one time. Therefore, complexity and industrial costs of a production process of the field plate are reduced.

In a possible implementation of this application, the field effect transistor may further include a flat layer located on the source-drain metal layer and a connection metal layer located on the flat layer. The flat layer includes a source connection hole and a drain connection hole. The source connection hole and the drain connection hole are usually filled with a conductive material such as tungsten. Through hole depths of the source connection hole and the drain connection hole are the same. This helps control a through hole etching process of the flat layer. The connection metal layer includes a source connection pad and a drain connection pad. The source connection pad is electrically connected to the source through the source connection hole, and the drain connection pad is electrically connected to the drain through the drain connection hole.

In a possible implementation of this application, the control gate and the metal gate form a gate structure. The control gate may be a stacked structure, and specifically includes a PGaN layer located on the channel layer and a TiN layer located on the PGaN layer. An orthographic projection of the TiN layer on the substrate may fall within a range of the PGaN layer. Specifically, the TiN layer and the PGaN layer may be formed by performing a patterning process for one time, and then a pattern of the TiN layer may be selectively shrunk in size based on a device design requirement, so that a size of the pattern of the TiN layer is less than a size of the PGaN layer.

In a possible implementation of this application, the control gate may alternatively be a single-layer structure, and specifically includes the PGaN layer. The TiN layer is disposed between the passivation layer and the gate metal layer. The control gate, the TiN layer, and the metal gate form a gate structure. After the passivation layer is manufactured, a TiN film and a gate metal film are directly grown on the passivation layer, and then patterns of the TiN layer and the gate metal layer are formed by performing a patterning process for one time, so that an orthographic projection of the TiN layer on the substrate coincides with the gate metal layer. In this case, a pattern of the TiN layer exists below both of the step and the metal gate.

In a possible implementation of this application, a layout may be defined and an etching process may be adjusted, so that a side wall that is of the step and that faces the metal gate may be perpendicular to a surface of the passivation layer, and a cross section of the step is similar to a rectangle. In other words, when patterning is performed on the gate metal layer, a cross section that forms a pattern is perpendicular to the surface of the passivation layer.

In a possible implementation of this application, to optimize electric field distribution between a gate and a drain, a layout may be defined and an etching process may be adjusted, so that a side wall that is of the step and that faces the metal gate tilts towards the drain, an included angle θ between the side wall that is of the step and that faces the metal gate and a surface that is of the step and that faces the passivation layer is less than 90 degrees, and a cross section of the step is similar to a trapezoid.

In a possible implementation of this application, there may be one step and one second-order field plate, and an orthographic projection of the first-order field plate on the substrate may be located between the second-order field plate and the metal gate. This helps form electric field gradient distribution between the gate structure and the drain, to further protect the gate structure.

In a possible implementation of this application, the second-order field plate may be disposed to be disconnected from the first-order field plate. In other words, structures of the two field plates are disconnected, and the first-order field plate is directly led out from the source. To ensure that the second-order field plate receives an electrical signal from the source, a second-order field plate connection hole may be further disposed in the flat layer, and the source connection pad is electrically connected to the second-order field plate through the second-order field plate connection hole. In other words, the second-order field plate receives the electrical signal from the source by using the source connection pad.

In a possible implementation of this application, the step may be a discontinuous structure. In other words, the step may be distributed in a plurality of sections, so that there may be a plurality of second-order field plates. In addition, the plurality of second-order field plates may be conducted with each other by using the first-order field plate. Alternatively, the second-order field plates may be disconnected with each other. Alternatively, one part of the second-order field plates may be conducted with each other by using the first-order field plate, and another part of the second-order field plates may be disconnected with each other. This is not limited herein. It should be noted that the second-order field plates disconnected from the first-order field plate need to be electrically connected to the source connection pad through the second-order field plate connection hole.

In a possible implementation of this application, a step that is discontinuous in a first direction may be formed by adjusting a layout of the gate metal layer, so that the second-order field plate may be arranged only in the first direction, and the first direction is a direction in which the source points to the drain. Alternatively, a step that is discontinuous in a second direction may be formed by adjusting a layout of the gate metal layer, so that the second-order field plate may be arranged only in the second direction, and the second direction is perpendicular to the first direction. Alternatively, a step that is discontinuous in both of a first direction and a second direction may be formed by adjusting a layout of the gate metal layer, so that second-order field plates may be arranged in both of the first direction and the second direction, or it may be considered that the second-order field plates are arranged in an array.

According to a second aspect, an embodiment of this application provides a production method for a field effect transistor, including: first, sequentially forming a channel layer, a control gate, and a passivation layer on a substrate, where the passivation layer includes a gate opening that exposes the control gate; forming a gate metal layer on the passivation layer, where the gate metal layer includes a metal gate and a step that are disposed at a spacing, and the metal gate is electrically connected to the control gate through the gate opening; forming an inter-layer dielectric layer on the gate metal layer, where the inter-layer dielectric layer and the passivation layer are etched to form a source opening and a drain opening that are respectively located on two sides of the metal gate, and an orthographic projection of the step on the substrate is located between the drain opening and the metal gate; and then, forming a source-drain metal layer on the inter-layer dielectric layer, where the source-drain metal layer includes a source and a drain that are respectively located on two sides of the metal gate, and a field plate electrically connected to the source, the source is electrically connected to the channel layer through the source opening, and the drain is electrically connected to the channel layer through the drain opening. The field plate extends from the source to one side of the drain and is disposed to be disconnected from the drain. An orthographic projection of the field plate on the substrate has an overlapping area with both of the metal gate and the step. The field plate includes a first-order field plate and a second-order field plate whose orthographic projections on the substrate are located between the metal gate and the drain. The second-order field plate is a part covering the step, and the first-order field plate is a part other than the second-order field plate.

According to the production method provided in this embodiment of this application, a pattern of the step is also formed while a pattern of the metal gate is formed on the gate metal layer, so that a part that is of the source-drain metal layer and that covers the step is raised to form the second-order field plate, a height difference is formed between the second-order field plate and a part that is not raised by the step, and the part that is not raised by the step forms the first-order field plate. In this way, an entire field plate needs to be processed by performing a patterning process for only one time. In other words, the entire field plate is formed by performing each of metal deposition, photoetching, and etching for one time. Therefore, complexity and industrial costs of a production process of the field plate are reduced.

In a possible implementation of this application, the method may further include: forming a flat layer on the source-drain metal layer, where the flat layer includes a source connection hole and a drain connection hole, and through hole depths of the source connection hole and the drain connection hole are the same, to help control a through hole etching process of the flat layer; and finally, forming a connection metal layer on the flat layer, where the connection metal layer includes a source connection pad and a drain connection pad, the source connection pad is electrically connected to the source through the source connection hole, and the drain connection pad is electrically connected to the drain through the drain connection hole.

In a possible implementation of this application, a layout may be defined and an etching process may be adjusted, so that a side wall that is of the step and that faces the metal gate may be perpendicular to a surface of the passivation layer, and a cross section of the step is similar to a rectangle. Alternatively, a side wall that is of the step and that faces the metal gate tilts towards the drain, an included angle θ between the side wall that is of the step and that faces the metal gate and a surface that is of the step and that faces the passivation layer is less than 90 degrees, and a cross section of the step is similar to a trapezoid. A distance between the step and a to-be-formed drain is generally greater than 0.5 um.

In a possible implementation of this application, one or more second-order field plates may be formed based on a location and a quantity of steps that are disposed. When there is one step and one second-order field plate, an orthographic projection of the first-order field plate on the substrate may be located between the second-order field plate and the metal gate. When there are a plurality of steps and a plurality of second-order field plates, the plurality of second-order field plates may be arranged in a first direction and/or a second direction. The first direction is a direction in which a to-be-formed source points to a drain, and the second direction is perpendicular to the first direction.

In a possible implementation of this application, the second-order field plate may be disposed to be disconnected from the first-order field plate. In other words, structures of the two field plates are disconnected, and the first-order field plate is directly led out from the source. To ensure that the second-order field plate receives an electrical signal from the source, a second-order field plate connection hole may be further disposed in the flat layer, and the source connection pad is electrically connected to the second-order field plate through the second-order field plate connection hole. In other words, the second-order field plate receives the electrical signal from the source by using the source connection pad.

In a possible implementation of this application, the control gate may include a PGaN layer and a TiN layer, and the PGaN layer is located between the TiN layer and the channel layer. Patterns of the PGaN layer and the TiN layer may be formed by performing a patterning process for one time. For example, a PGaN film and a TiN film may be grown on the channel layer, then the PGaN film and the TiN film are etched, and a reserved PGaN layer and TiN layer are used as the control gate. In addition, transverse size shrinking processing may be selectively performed on the TiN layer based on a requirement.

In a possible implementation of this application, when the control gate includes only the PGaN layer, before the gate metal layer is deposited, a TiN layer independent of the gate metal layer may be further formed on the passivation layer, and then the TiN layer and the gate metal layer that have a same pattern may be formed by performing a patterning process for one time.

According to a third aspect, this application provides an electronic circuit, where the electronic circuit includes a circuit board and a field effect transistor that is disposed on the circuit board and that is provided in each implementation of the first aspect of this application.

### BRIEF DESCRIPTION OF DRAWINGS

FIG. 1a is a schematic diagram of a cross-section structure of a field effect transistor having a dual-field plate in an existing technology;
FIG. 1b is a schematic diagram of a cross-section structure of another field effect transistor having a dual-field plate in an existing technology;
FIG. 2 is a schematic diagram of a cross-section structure of a field effect transistor according to an embodiment of this application;
FIG. 3 is a schematic diagram of a cross-section structure of another field effect transistor according to an embodiment of this application;
FIG. 4 is a schematic diagram of a cross-section structure of another field effect transistor according to an embodiment of this application;
FIG. 5 is a schematic diagram of a cross-section structure of another field effect transistor according to an embodiment of this application;
FIG. 6 is a schematic diagram of a cross-section structure of another field effect transistor according to an embodiment of this application;
FIG. 7 is a schematic diagram of a structure of a top view of a field effect transistor according to an embodiment of this application;
FIG. 8 is a schematic diagram of a structure of a top view of another field effect transistor according to an embodiment of this application;
FIG. 9 is a schematic diagram of a structure of a top view of another field effect transistor according to an embodiment of this application;
FIG. 10 is a schematic flowchart of a production method for a field effect transistor according to an embodiment of this application; and
FIG. 11a and FIG. 11b are schematic diagrams of structures after each step in a production method is completed according to an embodiment of this application.

### Reference numerals:

1: substrate; 2: channel layer; 3: control gate; 30: gate structure; 31: PGaN layer; 32: TiN layer; 4: passivation layer; 41: gate opening; 5: gate metal layer; 51: metal gate; 52: step; 6: inter-layer dielectric layer; 61: source opening; 62: drain opening; 7: source-drain metal layer; 71: source; 72: drain; 73: field plate; 731: first-order field plate; 732: second-order field plate; 8: flat layer; 81: source connection hole; 82: drain connection hole; 83: second-order field plate connection hole; 9: connection metal layer; 91: source connection pad; 92: drain connection pad; X: first direction; and Y: second direction.

### DESCRIPTION OF EMBODIMENTS

To make the objectives, technical solutions, and advantages of this application clearer, the following further describes this application in detail with reference to the accompanying drawings.

An/a AlGaN/GaN heterojunction HEMT structure based on a GaN material has excellent characteristics such as high electron mobility, high 2DEG surface density, high chemical stability, high frequency, and high power, so that a device made of the GaN material has obvious advantages in both of the radio frequency field and the power electronics field. Therefore, a field effect transistor provided in embodiments of this application may be widely used as a component of an electronic circuit in various scenarios. For example, the field effect transistor is widely used in a fifth-generation mobile communications technology (5th generation of wireless communications technologies, 5G) wireless communications base station, a power electronic component, and the like in the fields of information receiving and sending, energy conversion, and a high-frequency switch.

A GaN field effect transistor mainly includes a channel layer, a source, a drain, and a gate. When the GaN field effect transistor is used, conduction of the source and the drain is controlled by a gate voltage. However, because the GaN material does not have a self-supporting substrate, the GaN material usually needs to be manufactured on a Si substrate by using an epitaxial growth method. However, because a large lattice mismatch and thermal mismatch exist between GaN and Si, a large quantity of defects exist in an epitaxial material of the GaN. These defects capture electrons. This causes a decrease in a carrier concentration in a working state of a device. Consequently, a "current collapse" effect occurs in the device. In other words, a dynamic on-resistance increases. As a result, working stability of a system is affected.

Currently, for the "current collapse" effect of the GaN field effect transistor, a source field plate (which may also be referred to as a field plate) with a step trend is introduced in a related technology to reduce an increase in a dynamic on-resistance of a device under a high voltage. Generally, a metal at a source end is led out and bypasses the gate to form a field plate, to improve field strength distribution in a vertical direction between the gate and the drain. Therefore, the gate is protected. Currently, in the industry, a structure of two field plates is generally used for a device with a voltage above 600 V. The two field plates are disposed at a specific location between the gate and the drain. After being connected to a low potential of a source, the field plates form electric field gradient distribution with a high voltage of the drain, to further protect the gate.

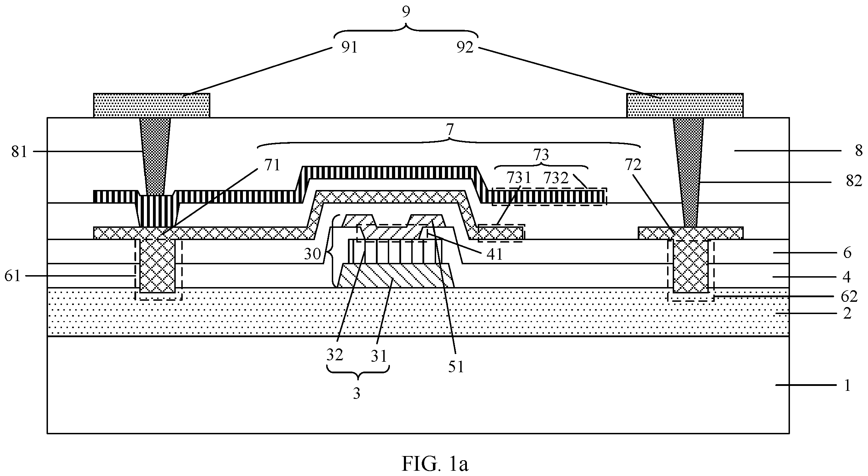

Refer to FIG. 1a. In an existing dual-field plate structure, after a gate structure 30 is manufactured by performing a mask (mask) process for three times, an inter-layer dielectric layer 6 is deposited, and an ohmic contact hole (the ohmic contact hole includes a source opening 61 and a drain opening 62) is opened at the inter-layer dielectric layer 6. A first-order field plate 731 is formed by bypassing one part of the gate structure 30 when depositing is performed at a source-drain metal layer 7 (which may also be referred to as an ohmic metal layer). In other words, the first-order field plate 731, a source 71, and a drain 72 are formed at the same time, and a second-order field plate 732 needs to be formed by using photoetching and etching processes after an additional layer of metal is deposited. Two field plates 73 are directly electrically connected to the source 71, and processing of the entire field plate 73 requires each of metal deposition, photoetching, and etching to be performed for two times, and requires dielectric deposition between the field plates to be performed for one time.

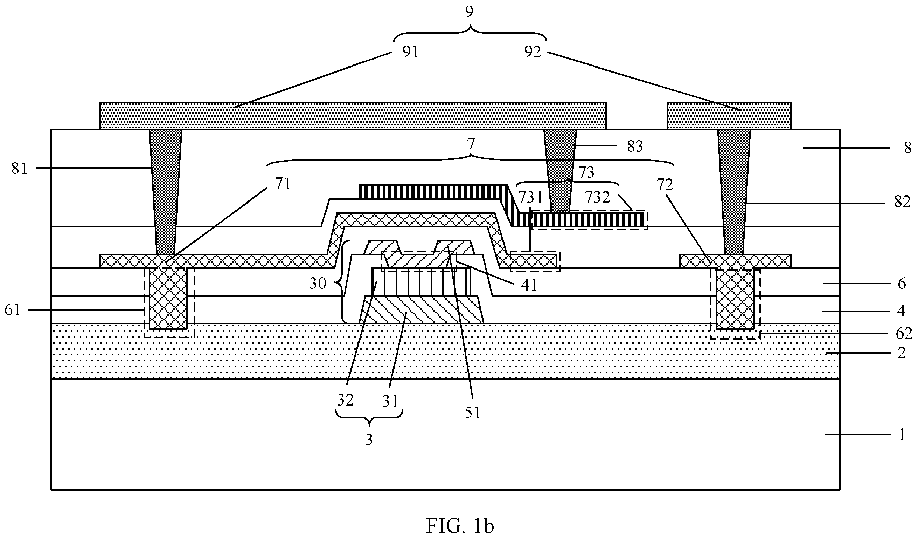

Refer to FIG. 1b. In another existing dual-field plate structure, processing of the gate structure 30 and the first-order field plate 731 is completely consistent with the structure shown in FIG. 1a, and the second-order field plate 732 also needs to deposit an additional layer of metal before being formed by using photoetching and etching processes. The difference lies in that, the first-order field plate 731 is directly electrically connected to the source 71, and the second-order field plate 732 is electrically connected to a source connection pad 91 through a second-order field plate connection hole 83. The processing of the entire field plate 73 also requires each of metal deposition, photoetching, and etching to be performed for two times, and requires dielectric deposition between the field plates to be performed for one time.

Refer to FIG. 1a and FIG. 1b. Although the existing dual-field plate structure can electrically protect the gate structure 30, a plurality of processes are added to form the second-order field plate 732, and a process flow is complex. In addition, thicknesses of flat layers 8 at different locations are different. In the dual-field plate structure shown in FIG. 1a, depths of a source connection hole 81 and a drain connection hole 82 at the flat layer 8 are different. In the dual-field plate structure shown in FIG. 1b, depths of the second-order field plate connection hole 83 and the source connection hole 81 are different. This makes it difficult to control a through hole etching process.

Therefore, an embodiment of this application provides a field effect transistor that can reduce a second-order field plate production process, a production method for the field effect transistor, and an electronic circuit. The following describes the field effect transistor in detail with reference to specific accompanying drawings and embodiments.

Terms used in the following embodiments are merely intended to describe specific embodiments, but are not intended to limit this application. As used in the specification and the appended claims of this application, the singular forms "one", "a", "the", "the foregoing", "the", and "this" are also intended to include, for example, "one or more", unless otherwise specified in the context.

Reference to "an embodiment", "some embodiments", or the like described in this specification indicates that one or more embodiments of this application include a specific feature, structure, or characteristic described with reference to embodiments. Therefore, statements such as "in one embodiment", "in some embodiments", "in some other embodiments", and "in still some other embodiments" that appear at different places in this specification do not necessarily refer to a same embodiment, but mean "one or more but not all embodiments", unless otherwise specially emphasized in another manner. The terms "include", "comprise", "have", and their variants all mean "include but are not limited to", unless otherwise specifically emphasized.

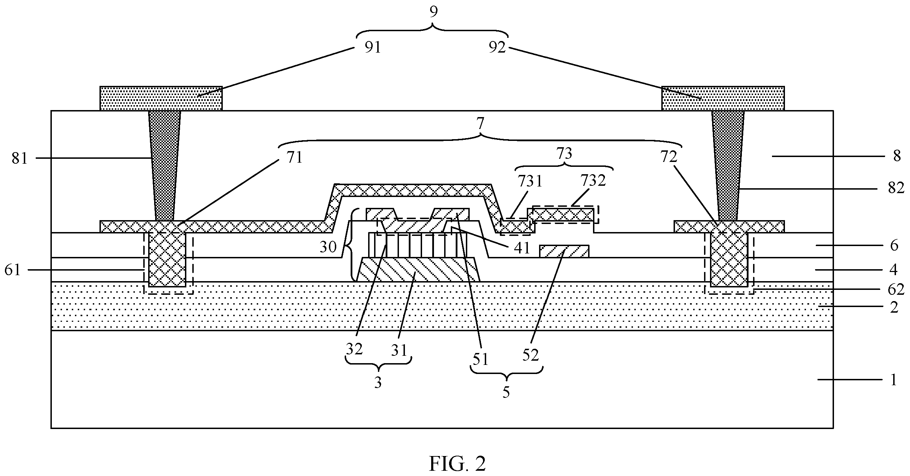

FIG. 2 shows an example of a schematic diagram of a cross-section structure of a field effect transistor according to an embodiment of this application. Refer to FIG. 2. In an embodiment of this application, the field effect transistor may include a channel layer 2 on a substrate 1, a control gate 3 on the channel layer 2, a passivation layer 4 on the control gate 3, a gate metal layer 5 on the passivation layer 4, an inter-layer dielectric layer 6 on the gate metal layer 5, and a source-drain metal layer 7 on the inter-layer dielectric layer 6. The passivation layer 4 includes a gate opening 41 that exposes the control gate 3. The gate metal layer 5 includes a metal gate 51 and a step 52 that are disposed at a spacing. The metal gate 51 is electrically connected to the control gate 3 through the gate opening 41. A source opening 61 and a drain opening 62 that pass through the inter-layer dielectric layer 6 and the passivation layer 4 are respectively located on two sides of the metal gate 51. An orthographic projection of the step 52 on the substrate 1 is located between the drain opening 62 and the metal gate 51. The source-drain metal layer 7 includes a source 71 and a drain 72 that are respectively located on two sides of the metal gate 51, and a field plate 73 electrically connected to the source 71. The source 71 is electrically connected to the channel layer 2 through the source opening 61, and the drain 72 is electrically connected to the channel layer 2 through the drain opening 62. The field plate 73 extends from the source 71 to one side of the drain 72 and is disposed to be disconnected from the drain 72. An orthographic projection of the field plate 73 on the substrate 1 has an overlapping area with the step 52. The field plate 73 specifically includes a first-order field plate 731 and a second-order field plate 732 whose orthographic projections on the substrate 1 are located between the metal gate 51 and the drain 72. The second-order field plate 732 is a part covering the step 52, and the first-order field plate 731 is a part other than the second-order field plate 732.

According to the field effect transistor provided in this embodiment of this application, a pattern of the step 52 is also formed while a pattern of the metal gate 51 is formed on the gate metal layer 5, so that a part that is of the source-drain metal layer 7 and that covers the step 52 is raised to form the second-order field plate 732, a height difference is formed between the second-order field plate 732 and a part that is not raised by the step 52, and the part that is not raised by the step 52 forms the first-order field plate 731. In this way, the processing of the entire field plate 73 requires a patterning process to be performed for only one time. In other words, the entire field plate is formed by performing each of metal deposition, photoetching, and etching for one time. Therefore, complexity and industrial costs of a production process of the field plate 73 are reduced.

Still refer to FIG. 2. In this embodiment of this application, the field effect transistor may further include a flat layer 8 located on the source-drain metal layer 7 and a connection metal layer 9 located on the flat layer 8. The flat layer 8 includes a source connection hole 81 and a drain connection hole 82. The source connection hole 81 and the drain connection hole 82 are usually filled with a conductive material such as tungsten. Through hole depths of the source connection hole 81 and the drain connection hole 82 are the same. This helps control a through hole etching process of the flat layer 8. The connection metal layer 9 includes a source connection pad 91 and a drain connection pad 92. The source connection pad 91 is electrically connected to the source 71 through the source connection hole 81, and the drain connection pad 92 is electrically connected to the drain 72 through the drain connection hole 82.

Still refer to FIG. 2. In this embodiment of this application, the control gate 3 and the metal gate 51 form a gate structure 30. The control gate 3 may be a stacked structure, and specifically includes a PGaN layer 31 located on the channel layer 2 and a TiN layer 32 located on the PGaN layer 31. An orthographic projection of the TiN layer 32 on the substrate 1 may fall within a range of the PGaN layer 31. Specifically, the TiN layer 32 and the PGaN layer 31 may be formed by performing a patterning process for one time, and then a pattern of the TiN layer 32 may be selectively shrunk in size based on a device design requirement, so that a size of the pattern of the TiN layer 32 is less than a size of the PGaN layer 31.

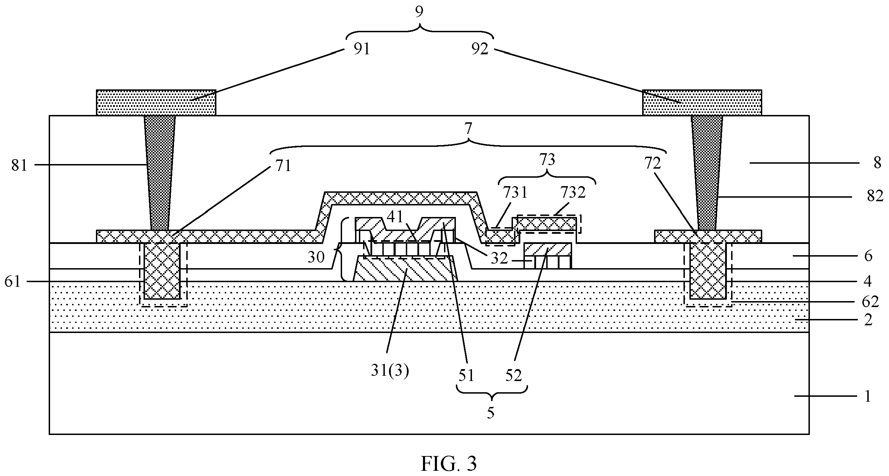

FIG. 3 shows an example of a schematic diagram of a cross-section structure of another field effect transistor according to an embodiment of this application. Refer to FIG. 3. In another embodiment of this application, the control gate 3 may be a single-layer structure, and specifically includes the PGaN layer 31. The TiN layer 32 is disposed between the passivation layer 4 and the gate metal layer 5. The control gate 3, the TiN layer 32, and the metal gate 51 form a gate structure 30. After the passivation layer 4 is manufactured, a TiN film and a gate metal film are directly grown on the passivation layer 4, and then patterns of the TiN layer 32 and the gate metal layer 5 are formed by performing a patterning process for one time, so that an orthographic projection of the TiN layer 32 on the substrate 1 coincides with the gate metal layer 5. In this case, a pattern of the TiN layer 32 exists below both of the step 52 and the metal gate 51.

Still refer to FIG. 2 and FIG. 3. In some embodiments of this application, a layout may be defined and an etching process may be adjusted, so that a side wall that is of the step 52 and that faces the metal gate 51 may be perpendicular to a surface of the passivation layer 4, and a cross section of the step 52 is similar to a rectangle. In other words, when patterning is performed on the gate metal layer 5, a cross section that forms a pattern is perpendicular to the surface of the passivation layer 4.

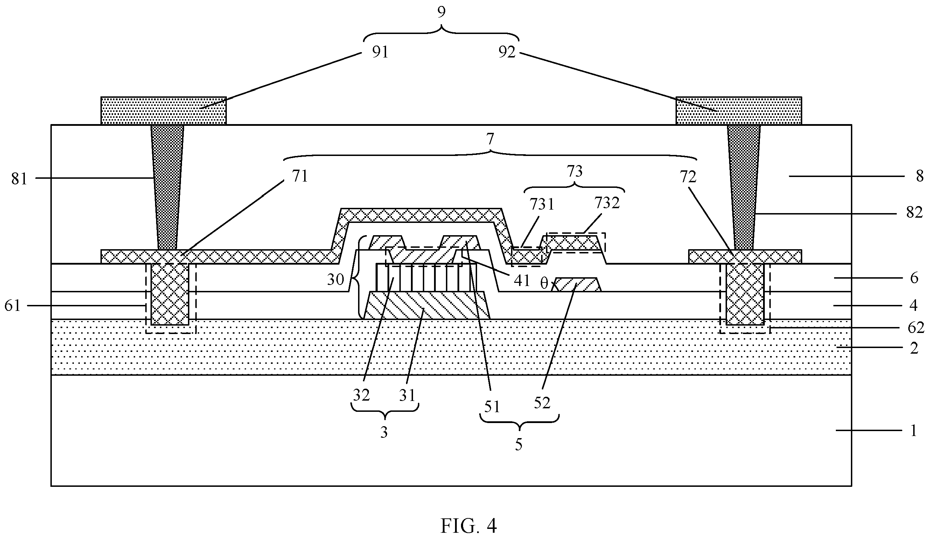

FIG. 4 shows an example of a schematic diagram of a cross-section structure of another field effect transistor according to an embodiment of this application. Refer to FIG. 4. In another embodiment of this application, to optimize electric field distribution between a gate and a drain, a layout may be defined and an etching process may be adjusted, so that a side wall that is of the step 52 and that faces the metal gate 51 tilts towards the drain 72, an included angle θ between the side wall that is of the step 52 and that faces the metal gate 51 and a surface that is of the step 52 and that faces the passivation layer 4 is less than 90 degrees, and a cross section of the step 52 is similar to a trapezoid.

Still refer to FIG. 2 to FIG. 4. In some embodiments of this application, there may be one step 52 and one second-order field plate 732. An orthographic projection of the first-order field plate 731 on the substrate 1 may be located between the second-order field plate 732 and the metal gate 51. This helps form electric field gradient distribution between the gate structure 30 and the drain 72. Therefore, the gate structure 30 is further protected.

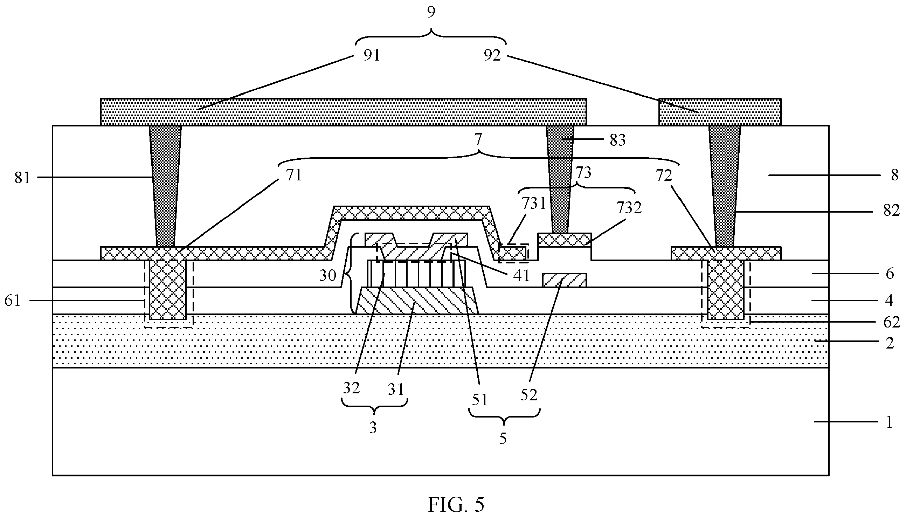

FIG. 5 shows an example of a schematic diagram of a cross-section structure of another field effect transistor according to an embodiment of this application. Refer to FIG. 5. In another embodiment of this application, the second-order field plate 732 may be disposed to be disconnected from the first-order field plate 731. In other words, structures of the two field plates are disconnected, and the first-order field plate 731 is directly led out from the source 71. To ensure that the second-order field plate 732 receives an electrical signal from the source 71, a second-order field plate connection hole 83 may be further disposed in the flat layer 8, and the source connection pad 91 is electrically connected to the second-order field plate 732 through the second-order field plate connection hole 83. In other words, the second-order field plate 732 receives the electrical signal from the source 71 by using the source connection pad 91.

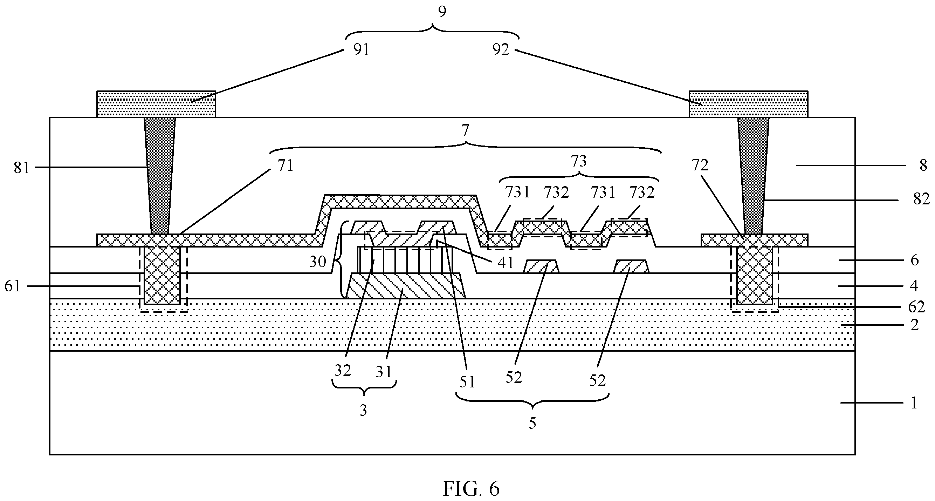

FIG. 6 shows an example of a schematic diagram of a cross-section structure of another field effect transistor according to an embodiment of this application. Refer to FIG. 6. In another embodiment of this application, the step 52 may be a discontinuous structure. In other words, the step 52 may be distributed in a plurality of sections, so that there may be a plurality of second-order field plates 732. In addition, the plurality of second-order field plates 732 may be conducted with each other by using the first-order field plate 731. Alternatively, the second-order field plates 732 may be disconnected with each other. Alternatively, one part of the second-order field plates 732 may be conducted with each other by using the first-order field plate 731, and another part of the second-order field plates 732 may be disconnected with each other. This is not limited herein. It should be noted that the second-order field plates 732 disconnected from the first-order field plate 731 need to be electrically connected to the source connection pad 91 through the second-order field plate connection hole 83 with reference to the structure shown in FIG. 5.

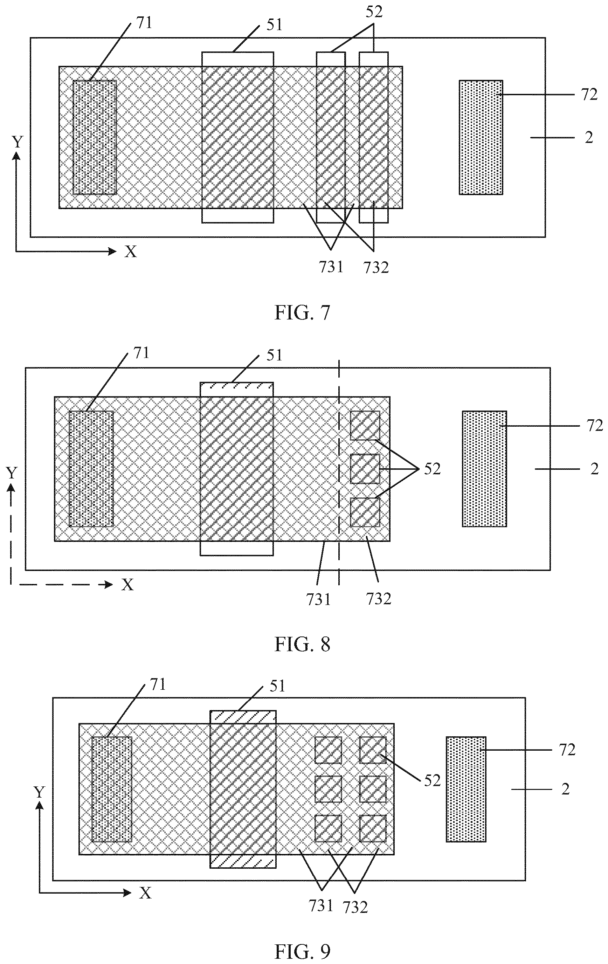

FIG. 7 shows an example of a schematic diagram of a top-view structure of a field effect transistor according to an embodiment of this application. FIG. 8 shows an example of a schematic diagram of a top-view structure of another field effect transistor according to an embodiment of this application. FIG. 9 shows an example of a schematic diagram of a top-view structure of another field effect transistor according to an embodiment of this application. Refer to FIG. 7. In an embodiment of this application, the step 52 that is discontinuous in a first direction X may be formed by adjusting a layout of the gate metal layer 5, so that the second-order field plate 732 may be arranged only in the first direction X, and the first direction X is a direction in which the source 71 points to the drain 72. Refer to FIG. 8. In another embodiment of this application, the step 52 that is discontinuous in a second direction Y may also be formed by adjusting a layout of the gate metal layer 5, so that the second-order field plate 732 may be arranged only in the second direction Y, and the second direction Y is perpendicular to the first direction X. Refer to FIG. 9. In another embodiment of this application, the step 52 that is discontinuous in both of a first direction X and a second direction Y may be formed by adjusting a layout of the gate metal layer 5, so that second-order field plates 732 may be arranged in both of the first direction X and the second direction Y, or it may be considered that the second-order field plates 732 are arranged in an array.

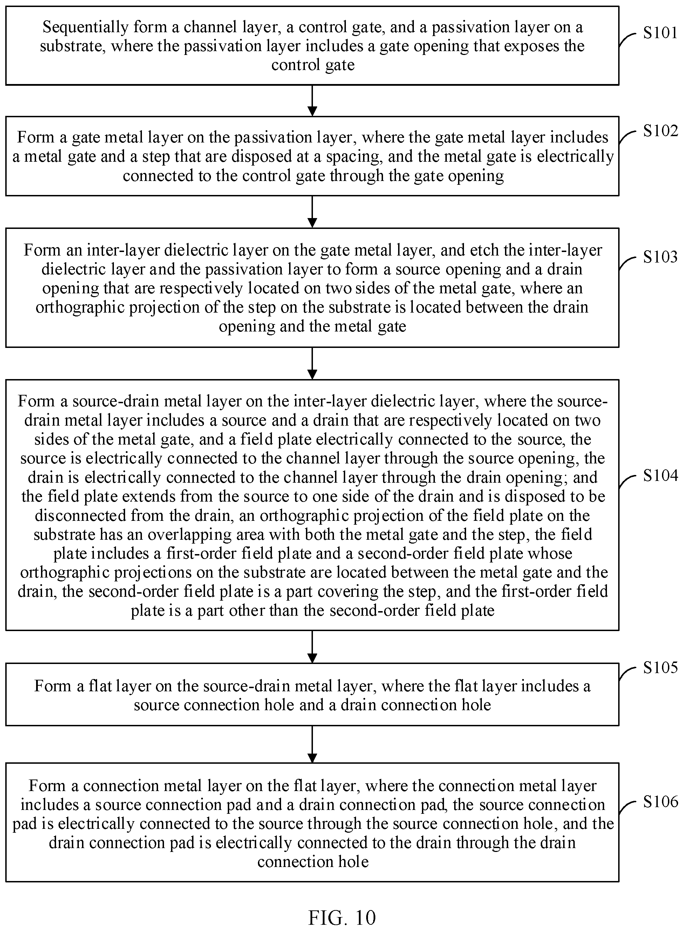

FIG. 10 shows an example of a schematic flowchart of a production method for a field effect transistor according to an embodiment of this application. Refer to FIG. 10. The production method mainly includes the following steps.

S101: Sequentially form a channel layer, a control gate, and a passivation layer on a substrate, where the passivation layer includes a gate opening that exposes the control gate.

S102: Form a gate metal layer on the passivation layer, where the gate metal layer includes a metal gate and a step that are disposed at a spacing, and the metal gate is electrically connected to the control gate through the gate opening.

S103: Form an inter-layer dielectric layer on the gate metal layer, and etch the inter-layer dielectric layer and the passivation layer to form a source opening and a drain opening that are respectively located on two sides of the metal gate, where an orthographic projection of the step on the substrate is located between the drain opening and the metal gate.

S104: Form a source-drain metal layer on the inter-layer dielectric layer, where the source-drain metal layer includes a source and a drain that are respectively located on two sides of the metal gate, and a field plate electrically connected to the source, the source is electrically connected to the channel layer through the source opening, and the drain is electrically connected to the channel layer through the drain opening; and
the field plate extends from the source to one side of the drain and is disposed to be disconnected from the drain, an orthographic projection of the field plate on the substrate has an overlapping area with both of the metal gate and the step, the field plate includes a first-order field plate and a second-order field plate whose orthographic projections on the substrate are located between the metal gate and the drain, the second-order field plate is a part covering the step, and the first-order field plate is a part other than the second-order field plate.

According to the production method provided in this embodiment of this application, a pattern of the step is also formed while a pattern of the metal gate is formed on the gate metal layer, so that a part that is of the source-drain metal layer and that covers the step is raised to form the second-order field plate, a height difference is formed between the second-order field plate and a part that is not raised by the step, and the part that is not raised by the step forms the first-order field plate. In this way, an entire field plate needs to be processed by performing a patterning process for only one time. In other words, the entire field plate is formed by performing each of metal deposition, photoetching, and etching for one time. Therefore, complexity and industrial costs of a production process of the field plate are reduced.

Still refer to FIG. 10. In this embodiment of this application, the production method may further include the following steps.

S105: Form a flat layer on the source-drain metal layer, where the flat layer includes a source connection hole and a drain connection hole, and through hole depths of the source connection hole and the drain connection hole are the same, to help control a through hole etching process of the flat layer.

S106: Form a connection metal layer on the flat layer, where the connection metal layer includes a source connection pad and a drain connection pad, the source connection pad is electrically connected to the source through the source connection hole, and the drain connection pad is electrically connected to the drain through the drain connection hole.

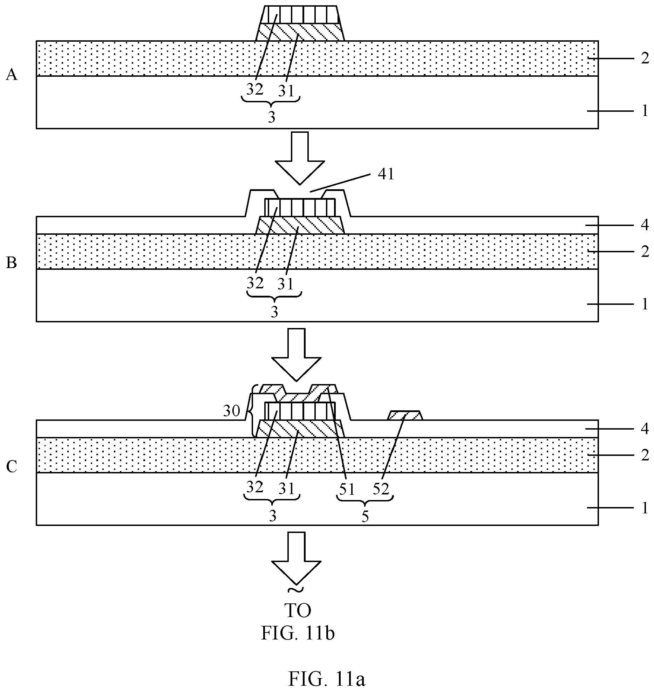

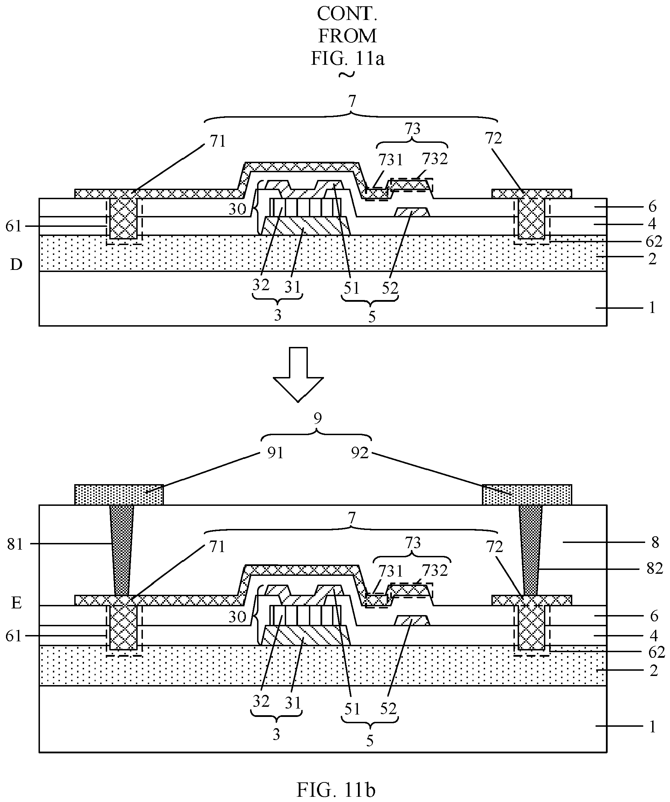

To facilitate understanding of the production method provided in this embodiment of this application, the following describes the steps in detail by using a structure shown in FIG. 4 as an example. FIG. 11a and FIG. 11b show examples of schematic diagrams of structures obtained after each step of producing the structure shown in FIG. 4 is completed. Refer to FIG. 11a and FIG. 11b. In this embodiment of this application, the production method includes the following steps.

1: Refer to A in FIG. 11a, patterns of a channel layer 2 and a control gate 3 are sequentially formed on a substrate 1.

Specifically, the substrate 1 may be manufactured by using a semiconductor material such as a group III-V compound, silicon, sapphire, or silicon carbide. As a function layer of the field effect transistor, the channel layer 2 is configured to form two-dimensional electron gas of the field effect transistor. The channel layer 2 may include a GaN layer and an AlGaN barrier layer that are disposed in a stacked manner, and the GaN layer is located between the AlGaN barrier layer and the substrate 1. A channel may be formed on a contact surface between the GaN layer and the AlGaN barrier layer, and the two-dimensional electron gas is located on the contact surface between the GaN layer and the AlGaN barrier layer. The source 71 and the drain 72 may form ohmic contact with the GaN layer. When the gate structure 30 controls the channel to be conducted, electrons are located in the channel, and the source 71 and the drain 72 may be conducted through electrons in the channel. When the gate structure 30 controls the channel to be disconnected, there is no free electrons in the channel, and the source 71 and the drain 72 are disconnected.

In an optional solution, before the channel layer 2 is formed on the substrate 1, a buffer layer may be further formed on the substrate 1. The buffer layer may be specifically formed on a surface of the substrate 1 by using processes such as chemical vapor deposition and epitaxial growth. The buffer layer serves as an optional structural layer. The buffer layer may be disposed based on a requirement. For example, when the substrate 1 can directly bear the channel layer 2, the buffer layer may not be disposed, and the channel layer 2 may be directly formed on the substrate 1. When a material of the channel layer 2 conflicts with a material of the substrate 1, and the channel layer 2 cannot be directly formed on the substrate 1, the buffer layer is disposed to isolate the substrate 1 from the channel layer 2. A material of the buffer layer needs to be selected based on a material of the substrate 1. This is not limited herein.

Specifically, the control gate 3 may include the PGaN layer 31 and the TiN layer 32, and the PGaN layer 31 is located between the TiN layer 32 and the channel layer 2. Patterns of the PGaN layer 31 and the TiN layer 32 may be formed by performing a pattering process for one time. For example, a PGaN film and a TiN film may be grown on the channel layer 2, then the PGaN film and the TiN film are etched, and a reserved PGaN layer 31 and TiN layer 32 are used as the control gate 3. In addition, transverse size shrinking processing may be selectively performed on the TiN layer 32 based on a requirement.

2: Refer to B in FIG. 11a, a passivation layer 4 is deposited, and a patterning process is performed for one time on the passivation layer 4 to form a gate opening 41 that exposes the control gate 3, and the gate opening 41 is generally less than a size of the control gate 3.

Specifically, a material of the passivation layer 4 includes but is not limited to SiO₂, Si₃N₄, AlO, AlN, or a stacked structure of a plurality of layers of dielectric films.

3: Refer to C in FIG. 11a, a gate metal layer 5 is deposited, and a patterning process is performed on the gate metal layer 5 to form a metal gate 51 and a step 52. The metal gate 51 is electrically connected to a control gate 3 through a gate opening 41. The step 52 is at a specific location between the gate structure 30 and a to-be-formed drain 72.

Specifically, a material of the gate metal layer 5 includes but is not limited to metal or a metal compound such as TiN, W, Ta, TaN, Pd or WSi.

Specifically, refer to FIG. 2, a layout may be defined and an etching process may be adjusted, so that a side wall that is of the step 52 and that faces the metal gate 51 may be perpendicular to a surface of the passivation layer 4, and a cross section of the step 52 is similar to a rectangle. Alternatively, refer to FIG. 4. A side wall that is of the step 52 and that faces the metal gate 51 tilts towards the drain 72, an included angle θ between the side wall that is of the step 52 and that faces the metal gate 51 and a surface that is of the step 52 and that faces the passivation layer 4 is less than 90 degrees, and a cross section of the step 52 is similar to a trapezoid. A distance between the step 52 and a to-be-formed drain 72 is generally greater than 0.5 um.

Specifically, one or more steps 52 may be manufactured based on a quantity of second-order field plates 732 that need to be formed. Refer to FIG. 7 to FIG. 9. A plurality of steps 52 may be arranged in a first direction X and/or a second direction Y. The first direction X is a direction in which a to -be-formed source 71 points to the drain 72, and the second direction Y is perpendicular to the first direction X.

Refer to FIG. 3. When the control gate 3 includes only the PGaN layer 31, before the gate metal layer 5 is deposited, a TiN layer 32 independent of the gate metal layer 5 may be further formed on the passivation layer 4, and then the TiN layer 32 and the gate metal layer 5 that have a same pattern may be formed by performing a patterning process for one time.

4: Refer to D in FIG. 11b, an inter-layer dielectric layer 6 is deposited, and a patterning process is performed for one time on the inter-layer dielectric layer 6 and the passivation layer 4 to open an ohmic contact window, to form a source opening 61 and a drain opening 62 that are respectively located on two sides of the metal gate 51; then a source-drain metal layer 7 (which may also be referred to as an ohmic metal) is deposited, and a patterning process is performed for one time on the ohmic metal, to form a source 71 and a drain 72 that are respectively located on two sides of the metal gate 51, and a field plate 73 electrically connected to the source 71, where the source 71 is electrically connected to the channel layer 2 through the source opening 61, and the drain 72 is electrically connected to the channel layer 2 through the drain opening 62, that is, a source ohmic metal leads out a low potential and bypasses an extension part of a gate structure 30 to form a first-order field plate 731, and a part above a step 52 forms a second-order field plate 732.

Specifically, one or more second-order field plates 732 may be formed based on a location and quantity of the steps 52. Refer to FIG. 2 to FIG. 5. When there is one step 52 and one second-order field plate 732, an orthographic projection of the first-order field plate 731 on the substrate 1 may be located between the second-order field plate 732 and the metal gate 51. Refer to FIG. 6 to FIG. 9. When there are a plurality of steps 52 and a plurality of second-order field plates 732, the plurality of second-order field plates 732 may be arranged in a first direction X and/or a second direction Y. The first direction X is a direction in which a to -be-formed source 71 points to the drain 72, and the second direction Y is perpendicular to the first direction X.

Specifically, a material of the ohmic metal includes but is not limited to metal or a metal compound such as Al, Ti, W, and TiN. A material of the inter-layer dielectric layer 6 includes but is not limited to a material such as SiO₂, Si₃N₄, or SiON.

5: Refer to E in FIG. 11b, a flat layer 8 is deposited, a patterning process is performed for one time on the flat layer 8 to form a source connection hole 81 and a drain connection hole 82, and the source connection hole 81 and the drain connection hole 82 are filled with tungsten plugs; and then a connection metal layer 9 is deposited, a patterning process is performed for one time on the connection metal layer 9 to form a source connection pad 91 and a drain connection pad 92, and a final device structure is completed.

Refer to FIG. 5. When the second-order field plate 732 is disposed to be disconnected from the first-order field plate 731, that is, structures of the two field plates are disconnected, the first-order field plate 731 is directly led out from the source 71. To ensure that the second-order field plate 732 receives an electrical signal from the source 71, a second-order field plate connection hole 83 may be further disposed in the flat layer 8, and the source connection pad 91 is electrically connected to the second-order field plate 732 through the second-order field plate connection hole 83. In other words, the second-order field plate 732 receives the electrical signal from the source 71 by using the source connection pad 91.

An embodiment of this application further provides an electronic circuit. The electronic circuit may include a circuit board and the field effect transistor according to any one of the foregoing embodiments provided in this application. The field effect transistor is disposed on the circuit board. A problem-resolving principle of the electronic circuit is similar to a problem-resolving principle of the foregoing field-effect transistor. Therefore, for an implementation of the electronic circuit, refer to the implementation of the foregoing field-effect transistor, and repeated content is not described again.

## Claims

1. Afield effect transistor, comprising:
a channel layer, located on a substrate;
a control gate, located on the channel layer;
a passivation layer, located on the control gate, wherein the passivation layer comprises a gate opening that exposes the control gate;
a gate metal layer, located on the passivation layer, wherein the gate metal layer comprises a metal gate and a step that are disposed at a spacing, and the metal gate is electrically connected to the control gate through the gate opening;
an inter-layer dielectric layer, located on the gate metal layer, a source opening and a drain opening that pass through the inter-layer dielectric layer and the passivation layer are respectively located on two sides of the metal gate, and an orthographic projection of the step on the substrate is located between the drain opening and the metal gate; and
a source-drain metal layer, located on the inter-layer dielectric layer, wherein the source-drain metal layer comprises a source and a drain that are respectively located on two sides of the metal gate, and a field plate electrically connected to the source, the source is electrically connected to the channel layer through the source opening, and the drain is electrically connected to the channel layer through the drain opening, wherein
the field plate extends from the source to one side of the drain and is disposed to be disconnected from the drain, an orthographic projection of the field plate on the substrate has an overlapping area with the step, the field plate comprises a first-order field plate and a second-order field plate whose orthographic projections on the substrate are located between the metal gate and the drain, the second-order field plate is a part covering the step, and the first-order field plate is a part other than the second-order field plate.

2. The field effect transistor according to claim 1, wherein a side wall that is of the step and that faces the metal gate is perpendicular to a surface of the passivation layer; or a side wall that is of the step and that faces the metal gate tilts towards the drain, and an included angle between the side wall that is of the step and that faces the metal gate and a surface that is of the step and that faces the passivation layer is less than 90 degrees.

3. The field effect transistor according to claim 1 or 2, wherein there are a plurality of second-order field plates.

4. The field effect transistor according to claim 3, wherein the plurality of second-order field plates are arranged in a first direction or a second direction, or the plurality of second-order field plates are arranged in an array, the first direction is a direction in which the source points to the drain, and the second direction is perpendicular to the first direction.

5. The field effect transistor according to claim 1 or 2, wherein there is one second-order field plate, and an orthographic projection of the first-order field plate on the substrate is located between the second-order field plate and the metal gate.

6. The field effect transistor according to any one of claims 1 to 5, further comprising:
a flat layer, located on the source-drain metal layer, wherein the flat layer comprises a source connection hole and a drain connection hole; and
a connection metal layer, located on the flat layer, wherein the connection metal layer comprises a source connection pad and a drain connection pad, the source connection pad is electrically connected to the source through the source connection hole, and the drain connection pad is electrically connected to the drain through the drain connection hole.

7. The field effect transistor according to claim 6, wherein the second-order field plate is disposed to be disconnected from the first-order field plate; and
the flat layer further comprises a second-order field plate connection hole, and the source connection pad is electrically connected to the second-order field plate through the second-order field plate connection hole.

8. The field effect transistor according to any one of claims 1 to 7, wherein the control gate comprises: a PGaN layer located on the channel layer and a TiN layer located on the PGaN layer, and an orthographic projection of the TiN layer on the substrate falls within a range of the PGaN layer.

9. The field effect transistor according to any one of claims 1 to 7, wherein the control gate comprises a PGaN layer; and
the field effect transistor further comprises a TiN layer, located between the passivation layer and the gate metal layer, wherein an orthographic projection of the TiN layer on the substrate coincides with the gate metal layer.

10. An electronic circuit, comprising a circuit board and the field effect transistor, disposed on the circuit board, according to any one of claims 1 to 9.

11. A production method for a field effect transistor, comprising:
sequentially forming a channel layer, a control gate, and a passivation layer on a substrate, wherein the passivation layer comprises a gate opening that exposes the control gate;
forming a gate metal layer on the passivation layer, wherein the gate metal layer comprises a metal gate and a step that are disposed at a spacing, and the metal gate is electrically connected to the control gate through the gate opening;
forming an inter-layer dielectric layer on the gate metal layer, and etching the inter-layer dielectric layer and the passivation layer to form a source opening and a drain opening that are respectively located on two sides of the metal gate, wherein an orthographic projection of the step on the substrate is located between the drain opening and the metal gate; and
forming a source-drain metal layer on the inter-layer dielectric layer, wherein the source-drain metal layer comprises a source and a drain that are respectively located on two sides of the metal gate, and a field plate electrically connected to the source, the source is electrically connected to the channel layer through the source opening, and the drain is electrically connected to the channel layer through the drain opening, wherein
the field plate extends from the source to one side of the drain and is disposed to be disconnected from the drain, an orthographic projection of the field plate on the substrate has an overlapping area with both of the metal gate and the step, the field plate comprises a first-order field plate and a second-order field plate whose orthographic projections on the substrate are located between the metal gate and the drain, the second-order field plate is a part covering the step, and the first-order field plate is a part other than the second-order field plate.

12. The production method according to claim 11, wherein a side wall that is of the step and that faces the metal gate is perpendicular to a surface of the passivation layer; or a side wall that is of the step and that faces the metal gate tilts towards the drain, and an included angle between the side wall that is of the step and that faces the metal gate and a surface that is of the step and that faces the passivation layer is less than 90 degrees.

13. The production method according to claim 11 or 12, wherein there are a plurality of second-order field plates.

14. The production method according to claim 13, wherein the second-order field plate is arranged in a first direction and/or a second direction, the first direction is a direction in which the source points to the drain, and the second direction is perpendicular to the first direction.

15. The production method according to claim 11 or 12, wherein there is one second-order field plate, and an orthographic projection of the first-order field plate on the substrate is located between the second-order field plate and the metal gate.
